Europäisches Patentamt

European Patent Office

Office européen des brevets

(11) Publication number: **0 267 852**
**A2**

## (12) EUROPEAN PATENT APPLICATION

(21) Application number: **87402547.1**

(22) Date of filing: **12.11.87**

(51) Int. Cl.⁴: $G\ 11\ C\ 11/40$

(30) Priority: **12.11.86 US 930220**

(43) Date of publication of application:
**18.05.88 Bulletin 88/20**

(84) Designated Contracting States: **DE FR GB IT NL**

(71) Applicant: **FAIRCHILD SEMICONDUCTOR CORPORATION**
**10400 Ridgeview Court P.O. Box 1500**
**Cupertino California 95014 (US)**

(72) Inventor: **Laymoun, Samir M.**
**655 Princeton Drive**
**Sunnyvale California 94087 (US)**

(74) Representative: **Chareyron, Lucien et al**
**Service Brevets SL c/o SCHLUMBERGER INDUSTRIES**
**50 avenue Jean-Jaurès B.P. 620-05**
**F-92542 Montrouge Cédex (FR)**

(54) **ECL read/write control circuit providing write-pull operation.**

(57) A read/write control circuit that operates with a write-pull function while ensuring a stable read level includes a two level series gated emitter coupled logic structure. One level is formed by a differential amplifier that receives a data signal and produces a pair of output signals that are related to the voltage at a reference node. The other level is made up of a second differential amplifier that receives a write control signal. One output node of the second differential amplifier is connected to the first differential amplifier, while the other output node is connected to the reference node by means of a resistor that provides a secure read level during transient states.

FIG. 2

**Description**

ECL READ/WRITE CONTROL CIRCUIT PROVIDING WRITE-PULL OPERATION

BACKGROUND OF THE INVENTION

The present invention is directed to read/write control circuits for determining information stored in a memory circuit, particularly read/write control circuits which employ ECL technology.

A basic memory cell typically comprises two storage transistors. Accordingly, a read/write control circuit for such a cell produces two related output signals, one for each transistor. During operation, the two output signals are held at the same voltage level when the memory circuit is in an idle state or while information is being read from it. When it is desired to write a bit of data into the memory cell, two different modes of operation are possible. In the mode that is in more general use today, one output signal is raised to a higher voltage level while the other output signal is brought to a lower voltage level. The choice of which signal goes high and which goes low will be dependent upon the binary value of the bit of data to be written into the cell. This type of operation is referred to as "push-pull", since one output signal is "pushed" up from the read voltage level while the other output signal is "pulled" down from this level.

While this type of circuit is in widespread use, it poses certain limitations upon the overall speed of operation of the memory circuit. If it is desired to increase the speed of operation, greater power demands are incurred, thus presenting the circuit designer with a compromise.

In an effort to avoid the performance penalties imposed by a push-pull type of control circuit, a write-pull only circuit has been suggested. In the operation of this type of circuit, one of the output signals is maintained at the read voltage level while the other signal is pulled to a low write level. While this type of circuit provides better performance capabilities in terms of speed and power, it has not been generally used in the past because it may not provide a stable read operation. In particular, under transient conditions the read voltage level can fluctuate, i.e. it may drop temporarily when switching from a write state to a read state, for example. As switching speed increases the magnitude of this fluctuation also increases. If the read voltage level drops low enough data could be lost since the low voltage effectively introduces an unwanted write operation at a time when data is being read from the cell.

BRIEF STATEMENT OF THE INVENTION

In view of the foregoing, the present invention seeks to provide a read/write control circuit that operates with a write-pull function while ensuring a stable read level. To this end, a read/write control circuit embodying the invention comprises a two level series gated emitter coupled logic structure. One level is formed by a differential amplifier that receives a data signal and produces a pair of output signals that are related to the voltage at a reference node. The other level is made up of a second differential amplifier that receives a write control signal. One output node of the second differential amplifier is connected to the first differential amplifier, while the other output node is connected to the reference node by means of a resistor that provides a secure read level during transient states.

Further features of the invention and the advantages offered thereby are described in detail hereinafter with reference to a preferred embodiment illustrated in the accompanying drawings.

BRIEF DESCRIPTION OF THE DRAWINGS

Figure 1 is a schematic circuit diagram of a memory cell circuit; and

Figure 2 is a schematic circuit diagram of a read/write control circuit embodying the present invention

DESCRIPTION OF THE ILLUSTRATED EMBODIMENTS

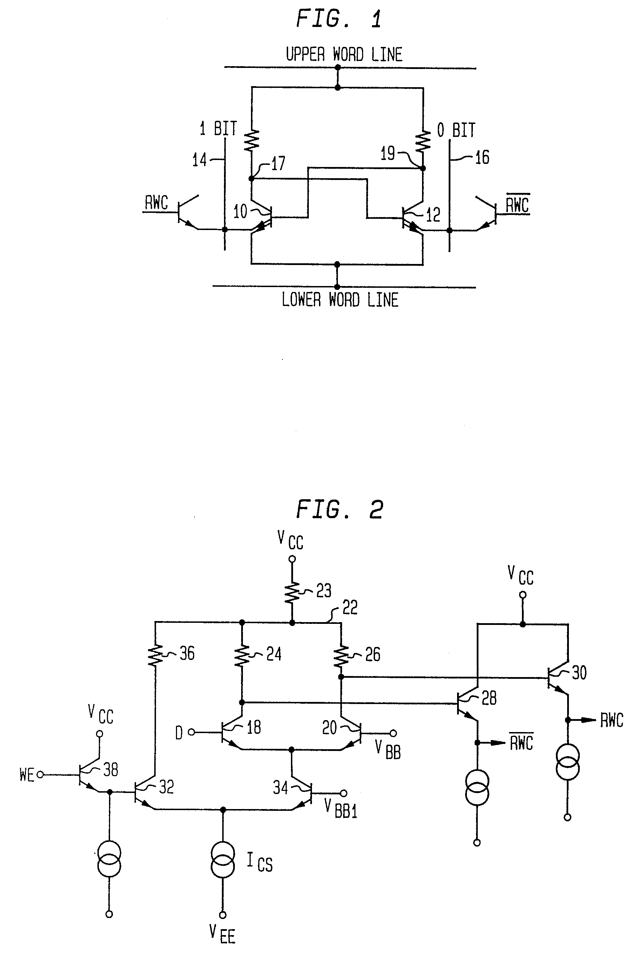

To facilitate an understanding of the present invention and the environment in which it operates, reference will first be made to a typical memory cell. Referring to Figure 1, the memory cell basically consists of a pair of cross-coupled transistors 10,12 that form a bistable flip-flop. As is well-known in this type of arrangement, one transistor is on while the other is off. One emitter of each transistor is connected to a respective bit line 14,16 that indicates whether the associated transistor is on or off. By detecting the voltage on the bit lines through suitable sensing circuitry (not shown), a determination can be made whether the memory cell is storing a logic one bit (transistor 12 on) or a logic zero bit (transistor 10 on).

To write a logic one or zero into the cell, an emitter of each transistor 10,12 receives a read/write control signal RWC or $\overline{\text{RWC}}$. During an idle state of the cell, and when the information in the cell is being read, the read/write control signals are both held at a high enough voltage level that they do not affect the operation of the transistors. For example, this voltage level may be the average of the high and low voltages that are employed at nodes 17 and 19 of the selected memory cell. When it is desired to write a bit of information into the cell, an appropriate one of the read/write control signals is pulled to a low voltage value. For example, to write a binary one into the cell, the complementary control signal $\overline{\text{RWC}}$ is pulled low. When this occurs, a large base-to-emitter voltage is developed across the transistor 12 to turn this transistor on. At the same time, the relatively small base-to-emitter voltage across the transistor 10 causes it to turn off. Thus, the cell nodes 17 and 19 are at high and low voltage levels, respectively, to indicate a binary one bit has been stored in the cell.

A read/write circuit for producing the control signals RWC and $\overline{\text{RWC}}$, in accordance with the present invention, is illustrated in Figure 2. The circuit basically comprises a two level, series gated emitter coupled logic (ECL) circuit. One level consists of a differential amplifier made up of a pair of emitter coupled transistors 18 and 20. The collector of each transistor is connected to a reference voltage node 22 by means of an associated load resistor 24 or 26. This node is connected to a high level voltage source $V_{CC}$ by means of a resistor 23. The junction of each collector and its associated load resistor forms an output node that is connected to the base of an emitter follower output transistor 28 or 30. The read/write control signals RWC and $\overline{RWC}$ are produced by the output transistors 30 and 28, respectively.

The base of the transistor 18 receives a binary data signal D. A reference voltage $V_{BB}$, which is preferably at about the midpoint of the high and low voltage levels for the data signal, is applied to the base of the other transistor 20. In place of the reference voltage $V_{BB}$ it is possible to use a complementary data signal $\overline{D}$, if differential logic is desired. However, since the present invention does not require differential logic, the use of a single data input signal is preferred. This approach eliminates the need to route dual data lines around the memory chip.

The second level of the read/write control structure comprises a second differential amplifier made up of two emitter coupled transistors 32 and 34. The collector of the transistor 34 is connected to the commonly coupled emitters of the transistor 18 and 20. The collector of the other transistor 32 is connected to the reference node 22 by means of a resistor 36. The emitters of the two transistors 32 and 34 are connected to a resistive or active current source $I_{CS}$. The base of the transistor 32 receives a write enable signal WE by means of an emitter-follower transistor 38. A reference voltage $V_{BB1}$ is applied to the base of the other transistor 34. The voltage $V_{BB1}$ is preferably equal to $V_{BB}$ minus the base-to-emitter voltage of the emitter-follower transistor 38.

In operation, when the circuit is in a read mode, the write enable signal WE is at a high logic level to render the transistors 38 and 32 conductive. This causes a gate current $I_{CS}$ to flow through the resistors 23 and 36 and the transistor 32. As a result, negligible current flows through the first differential amplifier, and both of the output signals RWC and $\overline{RWC}$ are at a READ level. This READ level is equal to $V_{CC}-[(R_{23}*I_{CS}) + V_{be}]$, where $R_{23}$ is the ohmic resistance of the resistor 23 and $V_{be}$ is the base-to-emitter voltage of the emitter-follower transistors 28 and 30. Preferably, $R_{23}$ is selected so that the READ voltage level is at about the midpoint of the high and low voltage levels at nodes 17 and 19 for the selected memory cell.

When the write enable signal WE goes low to perform a write operation, the transistors 38 and 32 turn off and the transistor 34 turns on. In this case, one of the transistors 18 or 20 will turn on to conduct the gate current. The particular one of these two transistors that turns on will be dependent upon the voltage level of the data signal D. For example, if the data signal D is high, the transistor 18 will turn on. In this case, the output signal RWC at the emitter follower transistor 30 will remain at the READ level while the transistor 28 will be rendered less conductive to pull the complementary signal $\overline{RWC}$ to the lower WRITE level. This lower WRITE level is equal to $V_{CC}-[(R_{23}+R_{24})I_{CS}+V_{be}]$.

Preferably, the resistors 24 and 26 have equal resistance values, and thus the WRITE level is the same for both output signals RWC and $\overline{RWC}$. However, if it is desired to provide a difference in the WRITE level for the two signals, the values of the resistors can be suitably adjusted.

A stable read operation is assured by the presence of the resistor 36. More particularly, when changing from one mode of operation to the other, e.g. write to read, the various junction capacitances and other parasitic capacitances in the read/write circuit must charge to an appropriate level. A resistance in the path of a charging current will affect the rate at which the capacitance charges. Thus, if no resistor were present in the collector path of the transistor 32, its associated capacitances will charge at a faster rate than the capacitances associated with the transistors 18, 20 and 34, which have the resistors 24 and 26 in their collector paths. If it is assumed that the signal RWC is at the WRITE level (transistor 20 is on), the transistor 32 could turn on before the transistors 34 and 20 turn off when the write enable signal WE switches from low to high. As a result, the READ level of the signal $\overline{RWC}$ can drop during the time that all three transistors are on. If this drop is low enough, the data that was written into the cell could be lost.

However, by providing the compensating resistor 36 in the collector path of the transistor 32, the RC time constant for charging its associated capacitances can be made equal to that of the transistor 34. Thus, the transistor 32 will not turn on until such time as the transistor 34 begins to turn off, thus maintaining the READ level constant.

Other advantages are provided by virtue of the series gating of the write enable and data signals through the circuit. For example, if the write enable input transistor 32 is emitter coupled to the data input transistor 18, a voltage differential must be provided between the logic high states for the WE and D signals in order to differentiate between these two signals. As a result, the effective noise margin of the circuit is reduced by this voltage differential. Further, the two transistors which receive the respective signals must be tightly matched. This requirement is difficult to achieve during production manufacturing, and results in a lowering of the yield of good circuits that can be obtained.

However, by employing the series gating arrangement, the need to shift the relative voltage levels of the write enable and data signals is avoided. Thus they can be used at their normal internal logic levels. In addition, precise matching of the transistors 32 and 18 is not required, thereby reducing failures and enhancing production yields.

It will be appreciated by those of ordinary skill in the art that the present invention can be embodied in other specific forms without departing from the spirit or essential characteristics thereof. The presently disclosed embodiment is therefore considered in all respects to be illustrative and not restrictive. The scope of the invention is indicated by the appended claims rather than the foregoing description, and all changes that come within the meaning and range of equivalents thereof are intended to be embraced therein.

## Claims

1. A read/write control circuit, comprising:
a first differential amplifier having at least one input terminal which receives a binary data signal and a pair of output terminals that are connected to a reference voltage node; and
a second differential amplifier which receives a binary write control signal and is connected to said first differential amplifier to provide series gating of said write control and data signals, said second differential amplifier operating in a first state in response to said write control signal to disable said first differential amplifier so that output signals at said two output terminals are at approximately the same predetermined voltage level and operating in a second state to enable said first differential amplifier so that the output signal at one of said output terminals is at approximately said predetermined voltage level while the output signal at the other output terminal is at a level lower than said predetermined voltage level.

2. The read/write control circuit of claim 1 wherein said predetermined voltage level is approximately equal to the voltage at said reference voltage node.

3. The read/write control circuit of claim 1 wherein said data signal and said write control signal have substantially the same logic voltage levels.

4. The read/write control circuit of claim 1 further including means for balancing the switching time constant of said second differential amplifier so that it is approximately the same as the switching time constant of said first differential amplifier.

5. An ECL read/write control circuit that provides a write-pull function with a secure read level, comprising:
a first differential amplifier comprising a pair of bipolar transistors whose emitters are connected in common and whose collectors are connected to a reference node by means of respective loads to form two output nodes, the base of at least one of said transistors having a data signal applied thereto;
a second differential amplifier comprising a pair of bipolar transistors whose emitters are connected in common to a voltage source, the collector of one of said transistors being connected to the commonly connected emitters of said first differential amplifier and the collector of the other transistor being connected to said reference node by means of a resistance; and

means for applying a write control signal to the base of one of said transistors of said second differential amplifier.

6. The ECL circuit of claim 5 wherein said reference node is connected to a second voltage source by means of a load resistance.

7. The ECL circuit of claim 5 further including means for applying a first reference voltage to the base of the other transistor of said first differential amplifier and means for applying a second reference voltage to the base of the other transistor of said second differential amplifier.

8. A read/write control circuit, comprising:
a differential amplifier having a pair of emitter coupled transistors whose collectors are connected to a first voltage source by means of respective load resistors to form a pair of output nodes;
means connecting the coupled emitters of said transistors to a second voltage source;
means for applying a data signal to the base of one of said transistors;
a write control transistor having an emitter-collector path connected between said first and second voltage sources and a base which receives a write control signal; and
means for balancing the switching time constant of said write control transistor to be approximately the same as that of said differential amplifier.

9. The control circuit of claim 8 wherein said balancing means comprises a resistor in the collector path of said write control transistor.

10. The control circuit of claim 8 wherein said data signal and said write control signal are binary signals which have substantially the same logic voltage levels.

11. The control circuit of claim 8 wherein said connecting means comprises a transistor having a collector connected to the coupled emitters of said differential amplifier and an emitter that is coupled to the emitter of said write control transistor.

## FIG. 1

UPPER WORD LINE

1 BIT     0 BIT

14    17    19    16

RWC    10    12    RWC

LOWER WORD LINE

## FIG. 2

$V_{CC}$

23

22

36    24    26

$V_{CC}$    30

38    18    20    $V_{BB}$    28    RWC

WE    32    34    $V_{BB1}$    RWC

D    RWC

$I_{CS}$

$V_{EE}$